# EUROPEAN PATENT SPECIFICATION

(11) **EP 4 224 647 B1**
(45) Date of publication and mention of the grant of the patent: **17.06.2026**
(21) Application number: 23165345.2
(22) Date of filing: 02.11.2018
(51) Int. Cl.: H01S 5/50, H01S 5/10, H01S 5/20

(54) **OPTICAL AMPLIFIER**
OPTISCHER VERSTÄRKER
AMPLIFICATEUR OPTIQUE

(43) Date of publication of application: 09.08.2023
(62) Divisional of application: 18204103.8
(73) Proprietor: Huawei Technologies Co., Ltd., Shenzhen, Guangdong 518129 (CN)
(72) Inventor: Lealman, Ian, 80992 Munich (DE)
(74) Representative: Thun, Clemens

(56) References cited:
- EP-A1- 2 287 983
- US-A- 6 167 070
- US-A1- 2003 042 477

## Description

### BACKGROUND

This invention relates to optical amplifiers, for example to improving the power efficiency of such devices.

High-performance and low-cost semiconductor optical amplifier (SOA) modules are used in applications such as large-capacity and high-speed optical access networks.

A conventional optical amplifier generally comprises a semiconductor block which has a front face or facet, a rear face or facet opposite to the front facet and an optical cavity formed therebetween. The cavity traditionally comprises an active layer interposed between layers of p- or n-type semiconductor material and defines a waveguide structure, which may be a ridge waveguide (RW) or a buried heterostructure (BH) waveguide. One or more coating layer(s), such as anti-reflection (AR) coatings, may be applied to the front and the rear facets.

The standard approach to making a high saturation power SOA is to design a device with a low optical confinement factor. The optical confinement factor of a waveguide is generally defined as the proportion of the light in the guided mode which is contained within the active region or waveguide core. i.e. the section of the structure that generates the optical gain in the SOA device. In such a device, only a low percentage of the guided mode is confined in the active region of the device where the light is generated. Examples include the dilute SOA disclosed in US 2004/0196540 A1 and slab-coupled optical waveguide structures, as disclosed in Juodawlkis et al, IEEE Photonics Tech. Lett. Vol. 17, No. 2 Feb 2005.

Simple tapered SOA designs in which the active width is increased in width along the cavity are also used to increase the saturation output power (Pₛₐₜ) of SOAs.

The document EP 2 287 983 A1 shows a broadband traveling wave semi-conductor optical amplifier with a tapered waveguide.

The document US 6,167,070 A shows an optical semi-conductor device and method of fabricating the same. Especially, the use of a optical confinement modification layer, which is tapered, is shown

The document US 2003/0042477 A1 shows a semi-conductor optical component and a method of fabricating the same. A tapered waveguide is also shown here.

### SUMMARY OF THE INVENTION

The present invention is defined by the independent claims. Further advantageous developments are shown by the dependent claims.

While these tapered designs are well understood, they are limited in the increase in Pₛₐₜ that can be provided. This is because, for the case of a ridge waveguide, as the ridge width of the amplifier is increased, the optical confinement factor and therefore gain per unit length of the SOA usually both increase slightly. This is also the case for a device having a buried heterostructure waveguide, where the confinement factor increases as the active width of the waveguide is increased.

Therefore, the increase in Pₛₐₜ is limited, to a first approximation, by W₂Γ₁/W₁ Γ₂ where W₁ and W₂ are the ridge widths at the start and end of the taper respectively and Γ₁ and Γ₂ are the modal confinement factors at the start and end of the taper respectively. Care must also be taken in the rate of ridge width increase, since the taper will support higher order lateral modes, and so the taper needs to be designed to remain close to adiabatic.

It is desirable to produce a SOA device with improved output saturation power characteristics and a method for manufacturing same.

According to one aspect there is provided an optical amplifier as defined in claim 1.

The decrease of the optical confinement along the propagation direction along the length of the cavity results in an improvement in the power efficiency of the device by reducing the optical confinement factor along the length of the SOA cavity at the same time as increasing the guide width. This allows for a much more efficient use of carrier injection. The present invention also allows for a reduction in the SOA length for a given saturation. A reduced chip size allows for a greater number of devices per wafer, reducing the chip cost compared to the existing commercially available devices.

The said direction is towards the rear face. This corresponds to the direction of amplification along the SOA cavity.

For another part of the cavity other than the said part the waveguide may have a constant width. For said another part of the cavity the waveguide may have a constant optical confinement factor. This allows the variable portion of the device to be integrated with sections of constant width and optical confinement factor at the input and output of the SOA device. A wide low confinement region adjacent to the output face may provide a uniform guide size at the output facet.

The waveguide may be a ridge waveguide. The waveguide may be a buried heterostructure waveguide. The described technique is therefore compatible with a variety of device structures.

The front face may be planar and the said length from the front face to the rear face is measured in a direction perpendicular to the front face.

The waveguide may be defined on a semiconductor substrate. This allows the layers of the waveguide to be deposited using common manufacturing methods.

The amplifier may further comprise a pair of electrodes, the optical amplifier being configured such that light emission can be stimulated from the cavity by applying a current across the electrodes. This allows for the amplification of light travelling along the cavity. The cavity may comprise a first semiconductor layer of a first doping type, a second semiconductor layer of a second doping type opposite to the first type, and an active region located between the first and second semiconductor layers, the first and second semiconductor layers being elongate in a direction extending between the front face and the rear face of the amplifier. This is a structure that is compatible with common semiconductor product manufacturing methods.

The cavity comprises a confinement modification layer whose thickness influences the optical confinement factor of the waveguide. This is a convenient way of varying the optical confinement factor along the cavity.

The waveguide may be symmetric about an axis parallel to the length of the cavity. This is a convenient waveguide configuration that is straightforward to manufacture.

The front face and/or the rear face may be cleaved facets that are coated with an anti-reflection coating. The coating may prevent reflection of light from the facets back into the cavity to optimize amplification.

The cavity may be inclined with respect to a direction perpendicular to the rear face. This may reduce the facet reflectivity and therefore reduce the gain ripple.

### BRIEF DESCRIPTION OF THE FIGURES

The present invention will now be described by way of example with reference to the accompanying drawings.

In the drawings:
Figure 1 shows a side view of an example of a SOA device.
Figures 2 shows a cross-section along A-A of Figure 1.
Figure 3 shows a plan view of the SOA device of Figure 1.
Figure 4 shows a plan view of another example of a SOA device.
Figure 5 shows schematic cross sections of the device of Figure 4 along: (a) section B-B and (b) section C-C.
Figures 6(a) and (b) show the TE0 mode profiles calculated at each end of the taper of the section 20 in Figure 4.
Figure 7 shows the results of simulations of the power loss in the TM0 and TM1 modes with the taper length of the waveguide.
Figure 8 shows another example of a waveguide for a SOA device.
Figure 9 shows an alternative structure of a SOA device with an etched confinement modification layer.
Figure 10 shows schematic cross sections for a SOA device with a buried heterostructure waveguide, equivalent to: (a) section B-B and (b) section C-C of the device in Figure 4.
Figure 11 shows the use of a variable mark period grating to achieve a variation in optical confinement factor along the length of the waveguide.
Figure 12 illustrates reflowing the grating of Figure 11 to achieve a smooth variation in thickness of the confinement modification layer: (a) before reflow and (b) after reflow.
Figure 13 illustrates the lateral alignment required between the confinement modification layer and the ridge waveguide when tapering the width of the confinement modification layer.

### DETAILED DESCRIPTION OF THE INVENTION

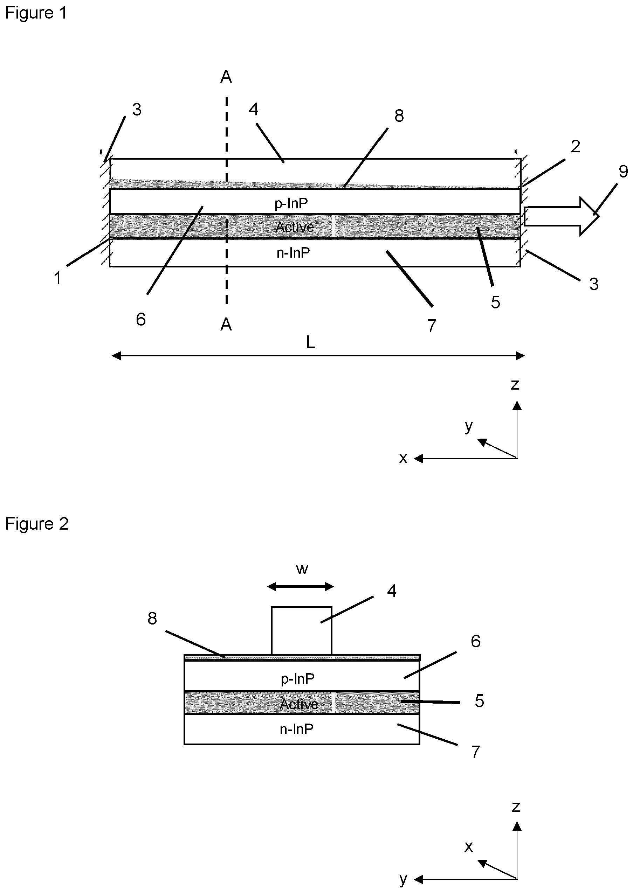

As illustrated in Figure 1, which shows a side view of one form of SOA, the device comprises a semiconductor block which has a front face or facet 1, a rear face or facet 2 opposite to the front face or facet and an optical cavity formed therebetween. The total length of the cavity is L. The cavity may be straight, as shown here, or the cavity may be inclined relative to a direction perpendicular to the front facet.

It is preferable that the front and rear facets are aligned parallel to one another. The rear facet may be orthogonal to the length of the cavity. Preferably the front facet is orthogonal to the length of the cavity. An anti-reflection (AR) coating 3 can be applied to one or preferably both of the front and rear facets.

The cavity comprises an active layer 5 which may be may be interposed between layers of p- and n-type semiconductor material, shown at 6 and 7 respectively. A confinement modification layer or in short confinement layer, whose thickness may be tapered along at least part of the length of the cavity, is shown at 8. The cavity may also comprise additional semiconductor outrigger (OR) layers beneath layers 5, 6, 7 and 8. In this example, the semiconductor layers are made from InP. However, other semiconductor materials, such as GaAs, may be used.

For example, in one embodiment, the device may comprise a base layer of InP beneath the outrigger layers that forms the majority of the structure. Layers such as the outriggers may be made from InGaAsP, which is lattice matched to InP, but which has a higher refractive index and has a bandgap wavelength significantly shorter than the wavelength of the gain material to maintain low optical loss. The active and surrounding layers may be composed of materials including InGaAsP, InGaAlAs, InAlAs or InGaAs of various compositions and strains chosen to provide gain at the correct wavelength range, across both TE (transverse electric) and TM (transverse magnetic) polarisations, waveguiding and other functions.

The material forming the cavity may be selectively doped in the region of the p- and n-type layers 6, 7. The optical cavity also comprises a waveguide layer 4, for instance and etched waveguide layer, or in short waveguide which provides lateral waveguiding. Light is emitted from the end of the waveguide at the rear face of the SOA device, shown at 9.

Figure 2 shows a cross-section along A-A of Figure 1. At each point along the length of the cavity, the waveguide layer 4 has a width w defined transverse to the length of the cavity. In the vertical section, the active layer 5, the confinement modification layer 8 and the semiconductor layers 6 and 7 all form part of the waveguide and guide the light in the vertical direction. The waveguide is thus formed by any layer or combination of layers that have a higher refractive index than the surrounding substrate and cladding layers, allowing the layer(s) to provide optical guiding.

The waveguide also has an optical confinement factor, Γ (Gamma). The optical confinement factor of a waveguide is defined as the proportion of the light in the guided mode which is contained within the active region or waveguide core. i.e. the section of the structure that generates the optical gain in the SOA device. The optical confinement factor of the waveguide may vary with position along the length of the cavity.

The waveguide may be a ridge waveguide, as in the example shown in Figures 1-3. The ridge waveguide may be created by etching parallel trenches in the material either side of the waveguide layer 4 to create an isolated projecting strip, typically less than 5 µm wide and several hundred µm long. A material with a lower refractive index than the waveguide material can be deposited at the sides of the ridge to guide injected current into the ridge. Alternatively, the ridge may be surrounded by air on the three sides that are not in contact with the substrate beneath the waveguide. The ridge provides the lateral waveguiding, since the other layers in the structure above the active layer have a higher index than the air or passivation layers (typically silica or silicon nitride) in the etched channel regions.

Referring to Figure 1, optical confinement layer 8 decreases in thickness along the length of the cavity in the direction from the front facet 1 to the rear facet 2. The thickness of the confinement modification layer 8 influences the optical confinement factor of the waveguide. As the thickness of the confinement modification layer decreases, the optical confinement factor of the waveguide also decreases and a lower proportion of the light in the guided mode is contained within the active region or waveguide core.

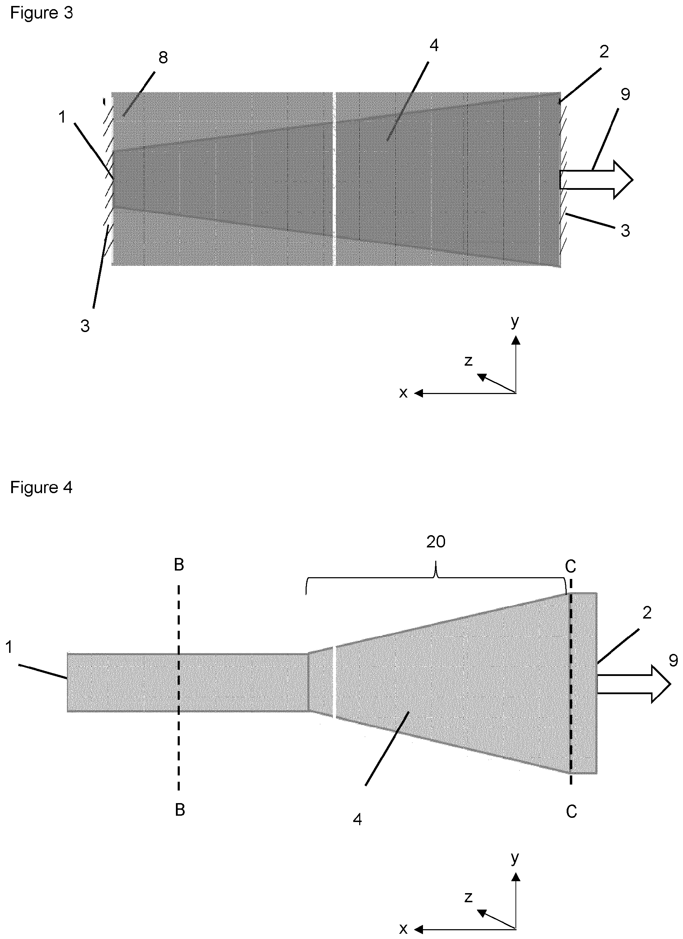

As shown in Figure 3, the waveguide also has an increasing width w in a direction along the length of the cavity, the said direction being from the front face towards the rear face of the cavity. Therefore, as the width of the waveguide increases, the optical confinement factor of the waveguide decreases in the said direction along the length of the cavity due to the progressively decreasing thickness of the confinement modification layer 8, as shown in the side view of Figure 1. In this example, the ridge width is narrow at the device input at the front facet 1 and widens in a direction towards the output facet 2.

Figure 4 shows a plan view of another example of a SOA having a ridge waveguide. In this embodiment, the waveguide 4 has one section of varying width 20 and other sections of uniform width in the direction perpendicular to the cavity length. In this example, the ridge width is narrow and constant at the device input at the front facet 1 and begins to widen from the centre of the cavity towards the output facet across region 20. A wide low confinement region adjacent to the output face 2 is provided to provide a uniform guide size at the cleaved output facet. The relative lengths of the constant width and tapered sections may be set by the required output power of the SOA, since the taper will need to start once the signal power in the guide approaches the safe power limit to avoid saturation. The minimum taper length may also be set by the need to ensure that the waveguide taper remains close to adiabatic to minimize scattering losses along its length.

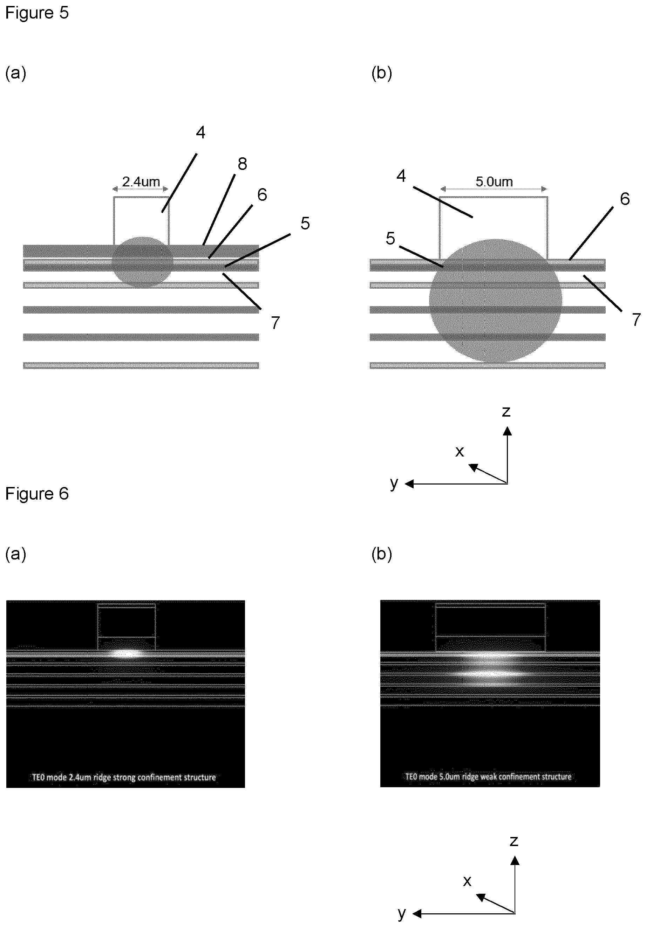

Figures 5 (a) and (b) show schematic representations of the cross-sectional structure of the SOA of Figure 4 along sections B-B and C-C respectively. The cross section in Figure 5 (a) has a ridge width of 2.4 microns and a 1.2Q confinement modification layer. In Figure 5 (b), the ridge width is 5.0 microns and the modification layer has been etched away, giving a large low confinement mode. In this embodiment, there are additional OR layers below the active layer. These layers may further decrease the confinement factor of the waveguide by pulling the mode down from the active layer.

The SOA thus has a narrow, high confinement ridge at the SOA input where amplified mode power is low. The ridge tapers up in width and confinement modification layer tapers down in thickness at the rear of the device where amplifier mode power is larger than at the input.

The variation in optical confinement is achieved by the use of the confinement modification layer 8 close to the active core of the device. Where the confinement modification layer 8 is thick and the ridge width is narrow close to the input facet of the device, this provides a single mode waveguide with a higher optical confinement factor and high gain per unit length where the signal power is low. The thickness of the confinement modification layer reduces towards the rear (output) facet of the device at the same time as the ridge or mesa width increases to reduce the optical confinement factor and gain per unit length where the optical power is high.

Such a device allows a high gain per unit length to be achieved with a small drive current where the signal strength is low, and reduces the gain per unit length at the output facet so that more current can be supplied to prevent saturation where the signal power is high.

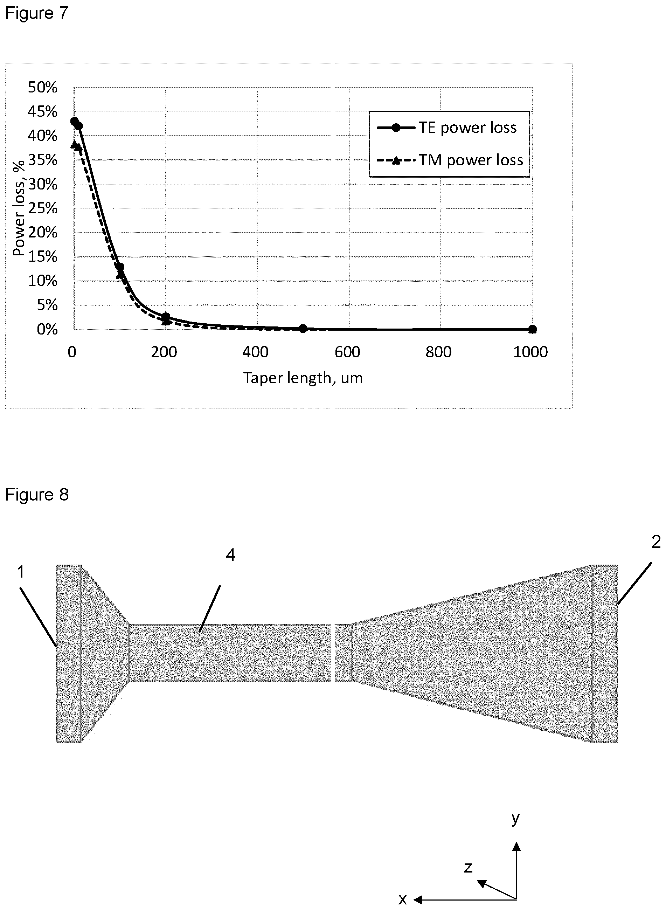

The structures of Figure 5(a) and (b) were modelled in FimmWave. Tables 1 and 2 show the FimmWave simulation box and the mode sizes calculated. Figure 6(a) and (b) show the TE0 mode profiles calculated at each end of the taper of the section 20 in Figure 4. Simulations of the taper loss, shown in Figure 7, also show that the losses for both the TE0 and the TM0 mode become very small for taper lengths greater than 200 µm, showing that the taper is adiabatic.

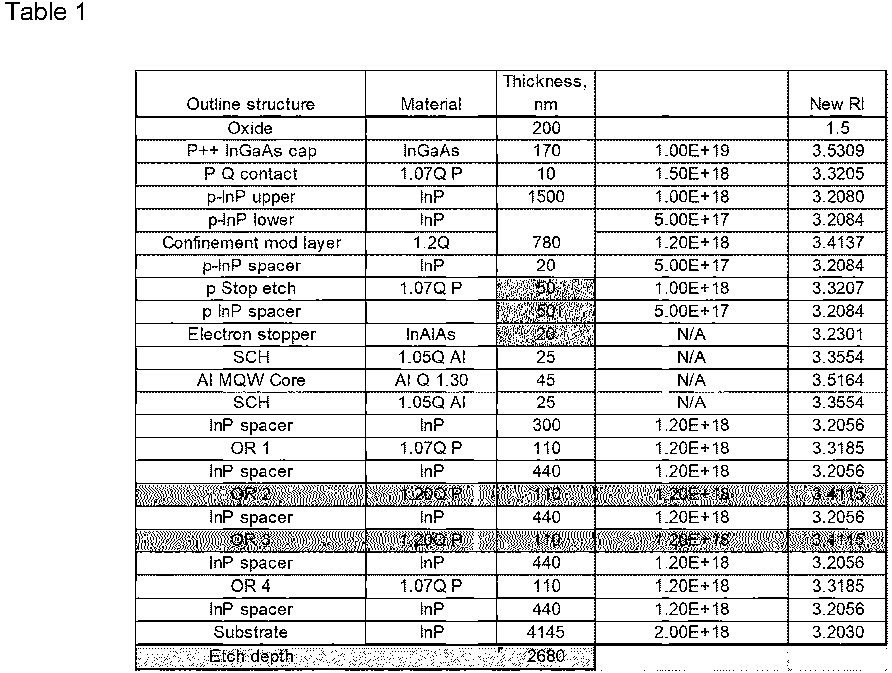

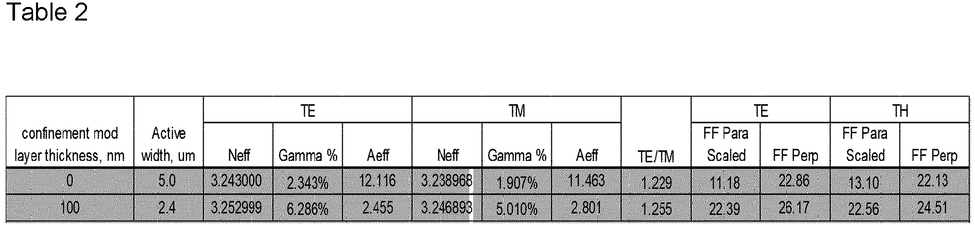

For semiconductor optical amplifier devices, the saturated output power (the output at which there is 3dB gain compression) at a fixed current density is set, to a first approximation, by the optical confinement factor, Γ (Gamma). To avoid signal patterning in SOAs (for bulk and MQW actives) it is generally found that the signal output power needs to be kept around 5dB below the saturated output power limit.

To compare the simulated result for the tapered structure, Table 3 takes the result for a conventional ridge waveguide SOA design of fixed confinement factor (optimized for low current) with the same active core and scales Γ*Length to show how the confinement factor Γ, chip length L and total current are related to the saturated output for conventional SOAs with a fixed confinement factor and uniform ridge width corresponding to the core of the SOA of Figure 4 (section B-B) and the low gamma facet (section C-C). This calculation assumes that the internal loss of each design is the same. Table 3 shows that to achieve a 20 dBm output power at 45 degrees C for a standard fixed width and fixed confinement factor SOA would require a chip length of around 6.6mm and a current of almost 2.1A.

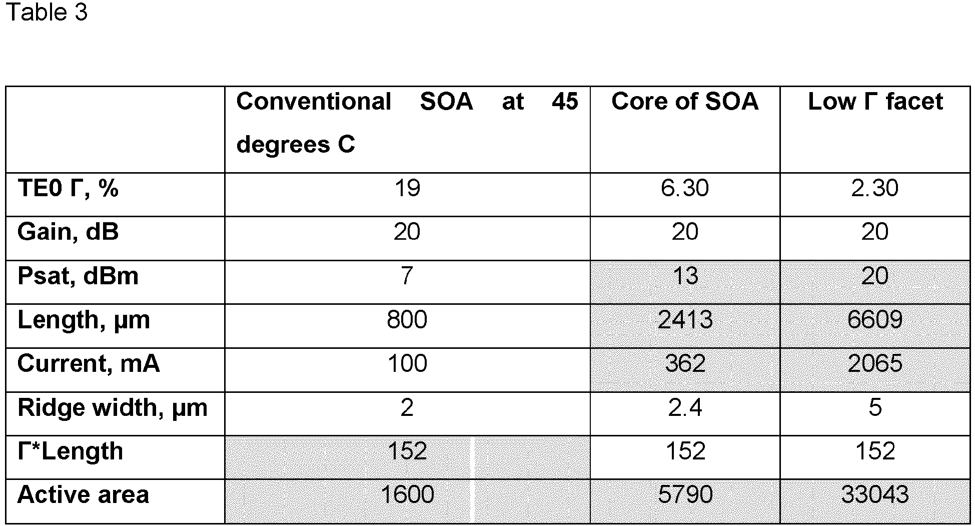

By tapering the waveguide, it is shown in the simulation of Table 4 that the same output power can be achieved for a chip length of around 2.9mm with a drive current of around 0.56A, providing not only a 5dB improvement in power efficiency, but also over 3dB reduction in chip length and therefore chip cost.

The calculation of current, gain and drive current for the variable confinement SOA (100µm step size) was based on a total gain of 20dB. Since the tighter mode calculated had a saturation power of 11dBm (and assuming a launch power of 0dBm), the taper starts after 1.4mm when 11dB gain is achieved. The total 20dB gain is reached after a 1.7mm long taper.

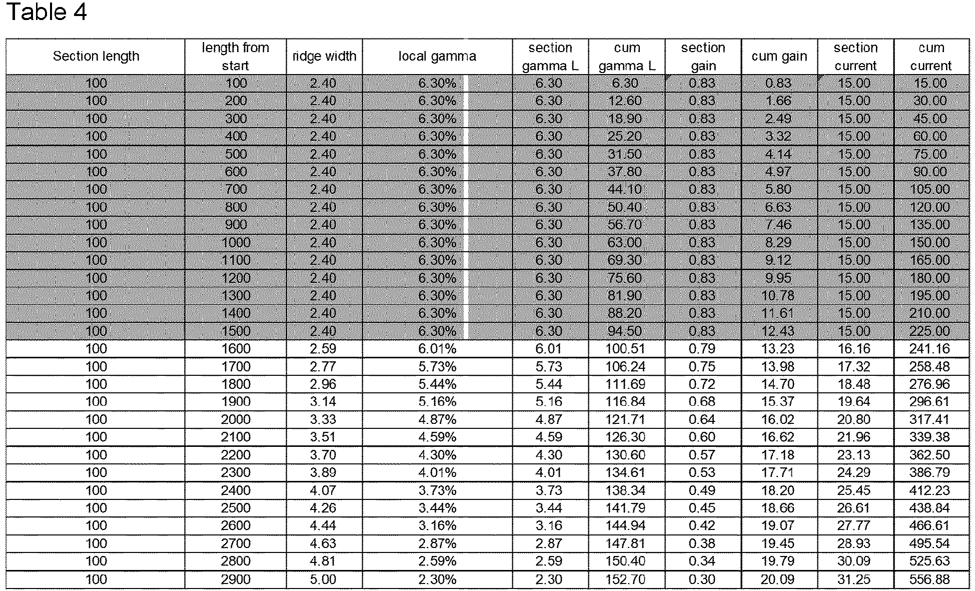

Thus the power efficiency is improved by reducing the optical confinement factor along the length of the SOA cavity at the same time as increasing the guide width. This allows much more efficient use of carrier injection and is specific to travelling wave devices such as SOAs.

The present invention provides an improved design that greatly improves the power efficiency of the current generation of high saturation power SOA devices and allows an SOA to be realized that offers a high saturated output power for a greatly reduced drive current (around 3x in the calculated embodiment). This power saving is key to future modules where power consumption is critical.

The present invention also allows for a reduction in the SOA length for a given saturation power (~2x in the calculated embodiment). A reduced chip size allows for a greater number of devices per wafer, reducing the chip cost compared to the existing commercially available devices.

While the initial simulations have been carried out for a very high power (20dBm) device, the performance benefits are also applicable to SOAs deigned for a variety of output saturation powers where reducing the required drive current is advantageous.

This approach is of use not only for stand-alone SOA devices, but could also be applied to monolithic devices that include SOAs as output power boosters. This includes standard telecommunications lasers, modulators and photonic integrated circuits. This approach also has applications outside of communications to improve the power efficiency of III-V devices such as MOPAs.

In a further embodiment, as shown in Figure 8, a short taper is used after the input facet of the device across a section of the cavity at least 200 µm in length, to ensure it is adiabatic, is included to reduce the device farfield angles at the input facet. For the simulation carried out this was shown to increase the chip length by ~100µm and drive current by around 30mA for the same 20dB gain and 20dBm Pₛₐₜ values.

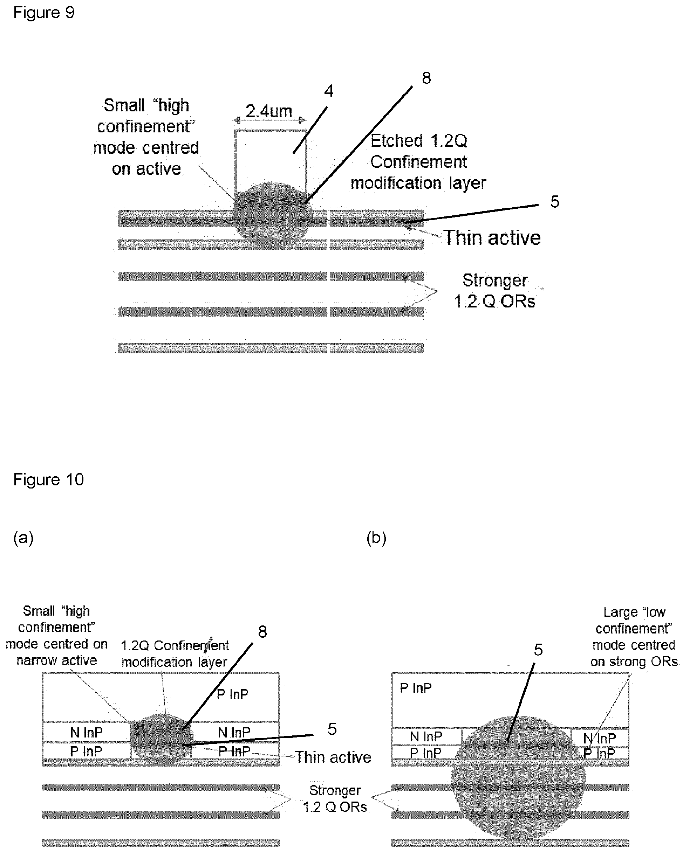

In another embodiment, show in cross section in Figure 9, the cavity has a ridge waveguide structure in which the confinement modification layer is etched through as part of the ridge above the active layer to reduce possible lateral current diffusion. This would only make a small change to the confinement factors achieved. This structure would also be compatible with a SOA device having a buried heterostructure (BH) waveguide (as well as being compatible with the ridge waveguides described in earlier embodiments). A schematic of the cross section of a device having a BH waveguide along a sections equivalent to B-B and C-C of Figure 4 are shown in Figures 10(a) and 10(b) respectively.

Thus the present invention can be applied to SOA devices having both ridge and BH waveguides.

The waveguide/cavity may additionally be inclined relative to a direction perpendicular to the front face of the cavity such that the waveguide slopes upwards towards the rear face. The waveguide may be inclined to the cavity length by an angle of 5°, 10°, 15° or 20°.

It is desirable to achieve a smooth variation in the thickness of the confinement modification layer 8 to limit reflection and scattering losses.

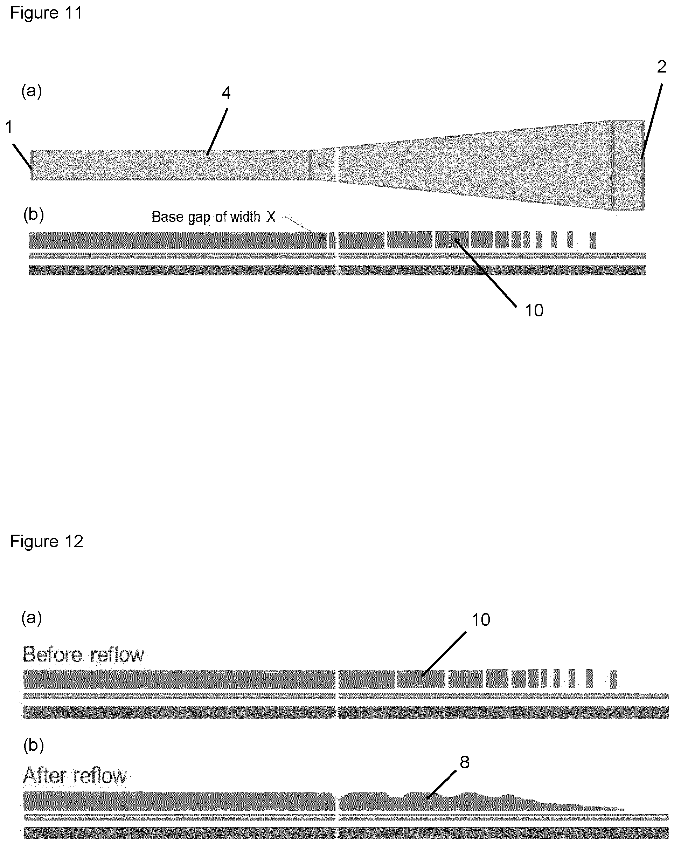

One method of achieving a variation in the thickness of the confinement modification layer is to use a variable tooth distributed feedback (DFB) grating, where the percentage of grating teeth vary along the length of the tapered section, as illustrated in Figure 11, which shows a side view along a length of ridge showing a schematic of a variable mark period "grating" layer 10 in a tapered section of the device. For a 1300nm SOA, assuming a fundamental period targeted at 1220nm, the grating period would need to be ~190nm, which would mean that the unit gap width X would be ~95nm.

In one embodiment, a 100nm thick confinement modification layer would result in a grating coupling coefficient Kappa of ~155cm⁻¹, which would act as a strong reflector. Therefore, the uncapped grating layer 10 shown in Figure 12(a) is preferably heated prior to regrowth to reflow the layer to reduce the reflection by smoothing out the layer thickness, as shown in Figure 12(b). This may limit reflection and scattering losses along the grating length relative to the un-flowed grating and result in a smooth variation in the thickness of the confinement modification layer 8.

If the variable mark period grating is left un-flowed, gain clamping may be used. Since the modal index of the guided mode varies along the taper, the reflections from each point will vary in wavelength. It is preferred to use a period (for the fundamental period near the 50:50 mark period section in the taper) that has a reflection on the extreme short wavelength side of the gain peak.

As an alternative, the period may be chirped along the length of the taper to provide gain clamping.

Other methods, may be used to realize the variable thickness confinement modification layer. Some of these alternative techniques are discussed below.

Selective area growth (SAG) can be used, which is simple to realize but tends to limit thickness variation of layer to a factor of 4 or 5. i.e. it does not allow it to be completely removed at the low confinement end of the structure, which would reduce the range of confinement factor modification.

Grey scale etching can also be used, which is realized using a grey scale photolithographic mask which is etched during the process used to etch the confinement modification layer.

Using a variable etch depth by selective etching can also be used. This method, published in Elec. Lett., Vol53, No 12 by NTT, uses a variable width mask layer to utilize the problematic variation in inductively coupled plasma or reactive ion etch rate in narrow mask channels. The etch rate increases as the mask gap size increases.

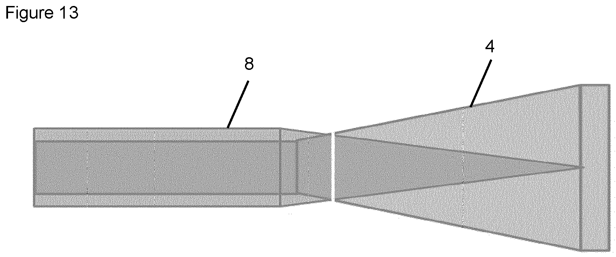

Lateral width tapering of the confinement modification layer, so that the layer doesn't extend over the whole of the ridge width, can be realized using a stepper or e-beam lithography to taper the width of the layer to around 0.1µm. However accurate lateral alignment is required between the confinement modification layer and the lateral ridge, as shown in Figure 13, which is a top down schematic showing how the width of the confinement modification layer 8 would need to be varied and aligned to main waveguide ridge 4.

## Claims

1. An optical amplifier having a front face (1), a rear face (2) and an optical cavity, the cavity having a length (L) defined between the front face and the rear face, the cavity comprising a waveguide (4) having an optical confinement factor and a width (w) defined transverse to the length of the cavity, wherein for at least part of the cavity the waveguide has an increasing width in a direction along the length of the cavity towards the rear face and in that part of the cavity a confinement modification layer (8) with a thickness that decreases along a propagation direction is present, resulting in the optical confinement factor of the waveguide decreasing in the said propagation direction along the length of the cavity towards the rear face,
wherein the rear face (2) is the output face of the optical amplifier,
wherein the said propagation direction is towards the rear face, and
wherein the cavity comprises an active layer (5) and a waveguide layer (4), wherein the waveguide layer (4) is located above the active layer (5).

2. The optical amplifier of claim 1, wherein for another part of the cavity other than the said part the waveguide has a constant width.

3. The optical amplifier of claim 2, wherein for said another part of the cavity the waveguide has a constant optical confinement factor.

4. The optical amplifier of any preceding claim, wherein the waveguide is a ridge waveguide, or wherein the waveguide is a buried heterostructure waveguide.

5. The optical amplifier of any preceding claim, wherein the front face is planar and the said length from the front face to the rear face is measured in a direction perpendicular to the front face.

6. The optical amplifier of any preceding claim, wherein the waveguide is defined on a semiconductor substrate.

7. The optical amplifier of any preceding claim, the amplifier further comprising a pair of electrodes, the optical amplifier being configured such that light emission can be stimulated from the cavity by applying a current across the electrodes.

8. The optical amplifier of any preceding claim, wherein the cavity comprises a first semiconductor layer (6) of a first doping type, a second semiconductor layer (7) of a second doping type opposite to the first type, and an active region (5) located between the first and second semiconductor layers, the first and second semiconductor layers being elongate in a direction extending between the front face and the rear face of the amplifier.

9. The optical amplifier of claim 8, wherein the confinement modification layer (8) is located above the active region (5).

10. The optical amplifier of claim 8 or 9, with lateral width tapering of the confinement modification layer (8), so that the confinement modification layer (8) does not extend over the whole of the waveguide width.

11. The optical amplifier of claim 10, wherein the width of the confinement modification layer (8) has been tapered using a stepper or e-beam lithography.

12. The optical amplifier of any one of claims 8 to 11, wherein the cavity comprises the waveguide layer (4) located above the confinement modification layer (8).

13. The optical amplifier of any preceding claim, wherein the front face and/or the rear face are cleaved facets that are coated with an anti-reflection coating.

## Patentansprüche

1. Optischer Verstärker mit einer Vorderseite (1), einer Rückseite (2) und einem optischen Resonator, wobei der Resonator eine Länge (L) aufweist, die zwischen der Vorderseite und der Rückseite definiert ist, wobei der Resonator einen Wellenleiter (4) mit einem optischen "Confinement"-Faktor und einer Breite (w) umfasst, die quer zu der Länge des Resonators definiert ist, wobei der Wellenleiter für mindestens einen Teil des Resonators eine zunehmende Breite in einer Richtung entlang der Länge des Resonators zu der Rückseite aufweist, und dass in jenem Teil des Resonators eine "Confinement"-Modifizierungsschicht (8) mit einer Dicke vorhanden ist, die entlang einer Ausbreitungsrichtung abnimmt, was dazu führt, dass der optische "Confinement"-Faktor des Wellenleiters in der Ausbreitungsrichtung entlang der Länge des Resonators zu der Rückseite abnimmt,
wobei die Rückseite (2) die Ausgabeseite des optischen Verstärkers ist, wobei die Ausbreitungsrichtung zu der Rückseite ist, und wobei der Resonator eine aktive Schicht (5) und eine Wellenleiterschicht (4) umfasst, wobei sich die Wellenleiterschicht (4) oberhalb der aktiven Schicht (5) befindet.

2. Optischer Verstärker gemäß Anspruch 1, wobei der Wellenleiter für einen von jenem Teil verschiedenen Teil des Resonators eine konstante Breite aufweist.

3. Optischer Verstärker gemäß Anspruch 2, wobei der Wellenleiter für den anderen Teil des Resonators einen konstanten optischen "Confinement"-Faktor aufweist.

4. Optischer Verstärker gemäß einem der vorhergehenden Ansprüche, wobei der Wellenleiter ein Stegwellenleiter ist, oder wobei der Wellenleiter ein vergrabener Heterostruktur-Wellenleiter ist.

5. Optischer Verstärker gemäß einem der vorhergehenden Ansprüche, wobei die Vorderseite planar ist und die Länge von der Vorderseite zu der Rückseite in einer Richtung rechtwinklig zu der Vorderseite gemessen wird.

6. Optischer Verstärker gemäß einem der vorhergehenden Ansprüche, wobei der Wellenleiter auf einem Halbleitersubstrat definiert ist.

7. Optischer Verstärker gemäß einem der vorhergehenden Ansprüche, wobei der Verstärker des Weiteren ein Paar Elektroden umfasst, wobei der optische Verstärker so konfiguriert ist, dass Lichtemission aus dem Resonator stimuliert werden kann, indem ein Strom über die Elektroden angelegt wird.

8. Optischer Verstärker gemäß einem der vorhergehenden Ansprüche, wobei der Resonator eine erste Halbleiterschicht (6) eines ersten Dotiertyps, eine zweite Halbleiterschicht (7) eines zweiten Dotiertyps, der entgegengesetzt zu dem ersten Typ ist, und eine aktive Region (5) umfasst, die sich zwischen der ersten und der zweiten Halbleiterschicht befindet, wobei die erste und die zweite Halbleiterschicht in einer Richtung länglich sind, welche sich zwischen der Vorderseite und der Rückseite des Verstärkers erstreckt.

9. Optischer Verstärker gemäß Anspruch 8, wobei die "Confinement"-Modifizierungsschicht (8) sich oberhalb der aktiven Region (5) befindet.

10. Optischer Verstärker gemäß Anspruch 8 oder 9, wobei die laterale Breite der "Confinement"-Modifizierungsschicht (8) sich verjüngt, so dass die "Confinement"-Modifizierungsschicht (8) sich nicht über die gesamte Wellenleiterbreite erstreckt.

11. Optischer Verstärker gemäß Anspruch 10, wobei die Breite der "Confinement"-Modifizierungsschicht (8) unter Verwendung eines Schrittmotors oder Elektronenstrahllithographie verjüngt worden ist.

12. Optischer Verstärker gemäß einem der Ansprüche 8 bis 11, wobei der Resonator die Wellenleiterschicht (4) umfasst, die sich oberhalb der "Confinement"-Modifizierungsschicht (8) befindet.

13. Optischer Verstärker gemäß einem der vorhergehenden Ansprüche, wobei die Vorderseite und/oder die Rückseite gespaltene Facetten sind, die mit einer Antireflexionsbeschichtung beschichtet sind.

## Revendications

1. Amplificateur optique ayant une face avant (1), une face arrière (2) et une cavité optique, la cavité ayant une longueur (L) définie entre la face avant et la face arrière, la cavité comprenant un guide d'onde (4) ayant un facteur de confinement optique et une largeur (w) définie transversalement à la longueur de la cavité, dans lequel, pour au moins une partie de la cavité, le guide d'onde a une largeur croissante dans une direction sur la longueur de la cavité vers la face arrière et dans cette partie de la cavité, une couche de modification de confinement (8) avec une épaisseur qui diminue le long d'une direction de propagation est présente, ce qui a pour résultat le fait que le facteur de confinement optique du guide d'onde diminue dans ladite direction de propagation sur la longueur de la cavité vers la face arrière,
dans lequel la face arrière (2) est la face de sortie de l'amplificateur optique,
dans lequel ladite direction de propagation est dirigée vers la face arrière, et
dans lequel la cavité comprend une couche active (5) et une couche de guide d'onde (4), dans lequel la couche de guide d'onde (4) est située au-dessus de la couche active (5).

2. Amplificateur optique selon la revendication 1, dans lequel, pour une autre partie de la cavité que ladite partie, le guide d'onde a une largeur constante.

3. Amplificateur optique selon la revendication 2, dans lequel, pour ladite autre partie de la cavité, le guide d'onde a un facteur de confinement optique constant.

4. Amplificateur optique selon une quelconque revendication précédente, dans lequel le guide d'onde est un guide d'onde à crête, ou dans lequel le guide d'onde est un guide d'onde à hétérostructure enterrée.

5. Amplificateur optique selon une quelconque revendication précédente, dans lequel la face avant est plane et ladite longueur de la face avant à la face arrière est mesurée dans une direction perpendiculaire à la face avant.

6. Amplificateur optique selon une quelconque revendication précédente, dans lequel le guide d'onde est défini sur un substrat semi-conducteur.

7. Amplificateur optique selon une quelconque revendication précédente, l'amplificateur comprenant en outre une paire d'électrodes, l'amplificateur optique étant configuré de telle sorte que l'émission de lumière puisse être stimulée à partir de la cavité par l'application d'un courant aux électrodes.

8. Amplificateur optique selon une quelconque revendication précédente, dans lequel la cavité comprend une première couche semi-conductrice (6) d'un premier type de dopage, une seconde couche semi-conductrice (7) d'un second type de dopage opposé au premier type, et une région active (5) située entre les première et seconde couches semi-conductrices, les première et seconde couches semi-conductrices étant allongées dans une direction s'étendant entre la face avant et la face arrière de l'amplificateur.

9. Amplificateur optique selon la revendication 8, dans lequel la couche de modification de confinement (8) est située au-dessus de la région active (5).

10. Amplificateur optique selon la revendication 8 ou 9, avec un rétrécissement latéral de la largeur de la couche de modification de confinement (8), de sorte que la couche de modification de confinement (8) ne s'étende pas sur toute la largeur du guide d'onde.

11. Amplificateur optique selon la revendication 10, dans lequel la largeur de la couche de modification de confinement (8) a été rétrécie à l'aide d'une lithographie par stepper ou par faisceau d'électrons.

12. Amplificateur optique selon l'une quelconque des revendications 8 à 11, dans lequel la cavité comprend la couche de guide d'onde (4) située au-dessus de la couche de modification de confinement (8).

13. Amplificateur optique selon une quelconque revendication précédente, dans lequel la face avant et/ou la face arrière sont des facettes clivées qui sont recouvertes d'un revêtement antireflet.
